# EUROPÄISCHE PATENTSCHRIFT

(11) **EP 0 284 909 B1**
(45) Veröffentlichungstag und Bekanntmachung des Hinweises auf die Patenterteilung: **26.05.1993**
(21) Anmeldenummer: 88104290.7
(22) Anmeldetag: 17.03.1988
(51) Int. Cl.: G01R 19/00, G01R 27/02, C23C 14/54, H01L 21/66

(54) **Sensor zur Messung des Stromes oder der Spannung von auf einem Referenzsubstrat vorhandenen elektrisch leitenden Schichten**
Sensor for measuring the current or the voltage of electric conductive layers on a reference chip
Détecteur pour la mesure du courant ou de la tension de couches électroconductrices sur un chip de référence

(30) Priorität: 31.03.1987 DE 3710596
(43) Veröffentlichungstag der Anmeldung: 05.10.1988
(73) Patentinhaber: SIEMENS AKTIENGESELLSCHAFT, 80333 München (DE)
(72) Erfinder: Schober, Konrad, Dipl.-Phys., D-8000 München 83 (DE)

(56) Entgegenhaltungen:
- EP-A- 0 067 432
- EP-A- 0 124 063

## Beschreibung

Die Erfindung betrifft einen Sensor nach dem Oberbegriff des Patentanspruches 1.

Bei der Fertigung von Dünnschichtschaltungen und integrierten Halbleiterschaltungen werden die Toleranzgrenzen bezüglich bestimmter Eigenschaften, wie zum Beispiel Schichtdicken und Schichtwiderstände von elektrisch leitenden Schichten auf Halbleitersubstraten zunehmend enger.

Bestehen solche Schichten zum Beispiel aus Legierungen, die durch gleichzeitiges Aufdampfen oder Zerstäuben von zwei oder mehr verschiedenen Targets (Co-Sputtern) hergestellt werden, so ist die genaue Kenntnis der Zusammensetzung der Schichten und demzufolge eine exakte Kontrolle des Schichterzeugungsprozesses von größter Bedeutung.

Bei Chrom/Nickel-Dünnschichtwiderständen muß der Temperaturkoeffizient des elektrischen Widerstands im Bereich von minus 25 bis plus 25 mal 10⁻⁶/K liegen. Da dieser von der Zusammensetzung abhängig ist, darf letztere in der Konzentration eines Bestandteiles um maximal ± 3 % Atomanteil abweichen.

Auch bei den in der VLSI-Technologie als niederohmiges Gate- bzw. Leiterbahnmaterial eingesetzten Tantalsilizidschichten wird der spezifische elektrische Widerstand, also die Abhängigkeit des Widerstands von der Dicke der Schicht stark von der Zusammensetzung beeinflußt. Außerdem können diese Schichten nur bei einer ganz bestimmten Zusammensetzung in einer oxidierenden Atmosphäre bei Temperaturen um 900°C eine SiO₂-Schutzschicht durch Oxidation des Siliziums auszubilden. Auch hier kann das Oxidwachstum nur dann reproduziert werden, wenn die Konzentration eines Bestandteils in der Tantalsilizidschicht nur geringfügig (maximal ± 2 Atomprozent) um einen festen Wert schwankt.

Zur genauen Kontrolle der Zusammensetzung einer Schicht ist eine in-situ-Bestimmung eines relevanten Meßwertes, zum Beispiel des elektrischen Widerstands, während der Schichterzeugung wünschenswert. Erschwerend kommt dabei hinzu, daß zur Erzielung homogener Schichten die zu beschichtenden Substrate während der Beschichtung bewegt werden müssen (zum Beispiel Rotationen oder Planetenbewegungen).

Eine Anordnung, die den elektrischen Widerstand und die Temperatur eines in einen evakuierten Rezipienten einer Beschichtungsanlage eingebrachten Referenzsubstrates zu messen vermag, ist im deutschen Patent 31 23 427 (oder europäische Patentanmeldung 0 067 432) beschrieben. Eine Probe definierter Geometrie ist hier auf einer als Doppelpalette ausgebildeten unabhängigen Meßeinheit angebracht. Der nach der Zwei- oder Vier-Punkt-Methode gemessene Widerstand wird durch eine elektronische Einrichtung im Pulscodemodulationsverfahren über einen Sender als digitales Signal nach außen übertragen. Elektronische Einrichtung, Sender und unabhängige Stromversorgung der Einrichtung (zum Beispiel Batterie) sind dabei isoliert im Inneren der Doppelpalette angeordnet.

Die beschriebene Vorrichtung weist jedoch den Nachteil auf, daß die Meßeinheit deutlich größere Ausmaße als ein Wafer oder Substrat aufweist (zum Beispiel Höhe des Wafers = 0,6 mm und Höhe der Meßeinheit zum Beispiel 15 mm). Dies erfordert demzufolge eine Vergrößerung der in ihren Ausmaßen knapp bemessenen Schleuse der Beschichtungs-oder Ätzanlage. Außerdem hat die Meßvorrichtung keine große Temperaturbeständigkeit und kann für Beschichtungsprozesse bei Temperaturen von größer als 90°C nicht mehr eingesetzt werden.

Aufgabe der vorliegenden Erfindung ist es daher, einen Sensor der eingangs angegebenen Art anzugeben, der die genannten Nachteile vermeidet.

Diese Aufgabe wird gemäß dem Kennzeichen des Patentanspruches 1 gelöst.

Es ist vorteilhaft, wenn die Kontaktelemente mit der Meßanordnung verbunden sind, die im Substrathalter oder am Substrathalter angeordnet ist. Dann nämlich ist die Meßanordnung nicht der Temperatur ausgesetzt, die auf die Substrate einwirkt. Die Folge ist, daß der Sensor mit Meßanordnung bei höheren Temperaturen einsetzbar ist, zum Beispiel bis 500°C, als die bekannte Meßanordnung.

Die Meßplättchen und die Trägerplättchen können vorteilhafterweise aus zwei von einem Distanzplättchen getrennten Blechen bestehen, von denen das eine Blech einen nach innen ragenden Nippel aufweist. Die Plättchen werden auf das Referenzsubstrat aufgeschoben und mit Hilfe des Nippels am Referenzsubstrat arretiert. Wenn der Nippel auf dem Blech der Trägerplättchen angeordnet ist, das bei aufgestecktem Trägerplättchen und auf dem Substrathalter angordneten Referenzsubstrat vom Substrathalter abgewandt ist, dann wird verhindert, daß bei der Beschichtung des Referenzsubstrates mit Plättchen unerwünschte Kontaktbrücken über die Trägerplättchen entstehen.

Weiterhin kann das Blech des Trägerplättchens, das bei Auflage des Referenzsubstrates auf dem Substrathalter aufliegt, dicker gewählt werden als die übrigen Bleche des Trägerplättchens und des Meßplättchens. Das dickere Blech legt dann den Abstand des Sensors zum Substrathalter fest und verhindert damit, daß die Meßplättchen auf dem Substrathalter aufliegen.

Andere Weiterbildungen der Erfindung ergeben sich aus den Unteransprüchen.

Anhand eines Ausführungsbeispieles, das in den Figuren dargestellt ist, wird die Erfindung weiter erläutert. Es zeigen
- Figur 1: ein Referenzsubstrat,
- Figur 2: eine Draufsicht auf ein Trägerplättchen,
- Figur 3: die Seitenansicht des Trägerplättchens nach Figur 2,
- Figur 4: die Draufsicht auf ein Meßplättchen,
- Figur 5: die Seitenansicht des Meßplättchens nach Figur 4,
- Figur 6: das Referenzsubstrat mit aufgestecktem Trägerplättchen und Meßplättchen,
- Figur 7: eine Prinzipdarstellung eines auf einem Substrathalter angeordneten Sensors.

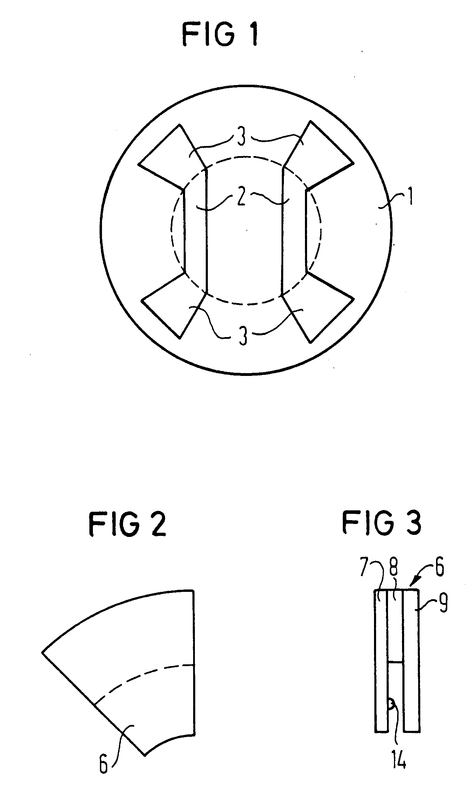

Figur 1 zeigt ein Referenzsubstrat 1, das zum Beispiel dieselben Abmessungen hat als die übrigen Substrate, die in einer Beschichtungsanlage beschichtet werden sollen. Auf dem Referenzsubstrat sind Leiterbahnen 2, 3 angeordnet, die zum Beispiel einen streifenförmigen Teil 2 und einen Kontaktbereich 3 aufweisen. Im Ausführungsbeispiel der Figur 1 sind zwei Leiterbahnen dargestellt, es können selbstverständlich auch mehr als zwei Leiterbahnen sein. Soll das Referenzsubstrat zur Temperaturmessung verwendet werden, dann kann im Bereich zwischen den Leiterbahnen 2 ein Thermoelement isoliert angeordnet sein. Ein solches Thermoelement ist in Figur 1 nicht dargestellt.

Bevor ein solches Referenzsubstrat 1 in die Beschichtungsanlage eingebracht wird, werden Meßplättchen 10 und Trägerplättchen 6 aufgesteckt. Die Trägerplättchen sind in ihrem Aufbau in Figur 2 und Figur 3 dargestellt. Sie bestehen aus Blechen 7 und 9, die von einem Distanzplättchen 8 getrennt sind. Das eine Blech 7 ist auf seiner nach innen zeigenden Seite mit einem Nippel 14 versehen. Wenn das Trägerplättchen 6 auf das Referenzsubstrat 1 aufgesteckt ist, dann dient der Nippel 14 zur Arretierung. Es ist zweckmäßig, daß das Blech 9 dicker ausgeführt ist als das Blech 7. Zum Beispiel kann das Blech 9 0,5 mm stark sein und das Blech 7 nur 0,3 mm. Dies hat den Vorteil, daß mit Hilfe des Bleches 9 der Abstand des Referenzsubstrates und der aufgesteckten Plättchen 6 und 10 zum Substrathalter 16 festgelegt wird.

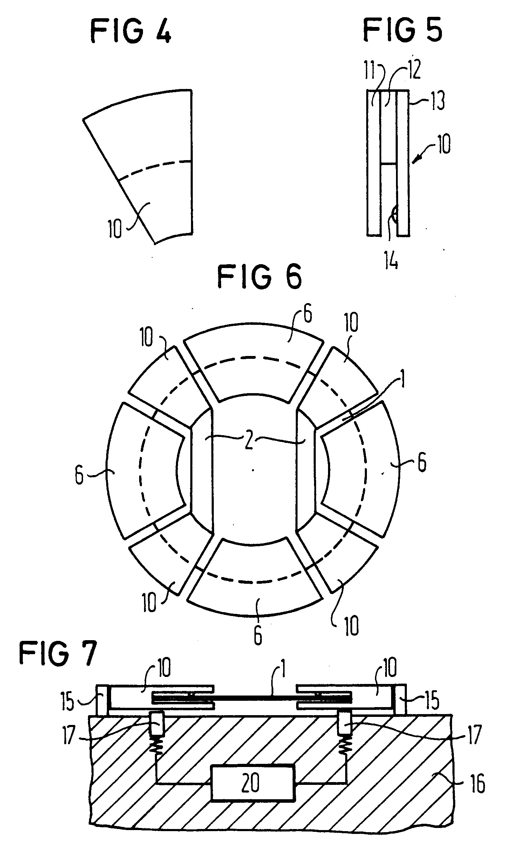

Der Aufbau der Meßplättchen 10 kann Figur 4 und Figur 5 entnommen werden. Auch hier sind Bleche 11 und 13 vorgesehen, die von einem Distanzplättchen 12 getrennt sind. Die Stärke der beiden Bleche 11 und 13 ist gleich und hat zum Beispiel den Wert von 0,3 mm. Auch hier ist an einem der Bleche, nämlich dem Blech 13 ein nach innen ragender Nippel 14 vorgesehen. Dieser Nippel 14 dient wiederum der Befestigung des Meßplättchens 10 am Referenzsubstrat 1. Da beim Meßplättchen 10 beide Bleche 11 und 13 gleich stark sind und zudem dünner sind als das Blech 9 eines Trägerplättchens 6, wird bei aufgestecktem Plättchen durch das Blech 9 des Trägerplättchens verhindert, daß die Meßplättchen 10 auf den Substrathalter 16 aufliegen können.

Figur 6 zeigt ein Referenzsubstrat 1 mit aufgestecktem Trägerplättchen 6 und Meßplättchen 10. Die Meßplättchen 10 werden dabei auf die Kontaktbereich 3 der Leiterbahnen 2, 3 auf dem Referenzsubstrat 1 aufgesteckt. Die Trägerplättchen 6 sind zwischen den Meßplättchen 10 auf das Referenzsubstrat 1 aufgesteckt. Die Verteilung der Trägerplättchen 6 muß so erfolgen, daß das Referenzsubstrat mit Plättchen gleichmäßig auf dem Substrathalter 16 aufliegt und damit zum Beispiel ein Kippen des Referenzsubstrates 1 nicht möglich ist. Die Anzahl der Meßplättchen 10 wird durch die Anzahl der Kontaktbereiche 3 festgelegt, die als Meßpunkte verwendet werden sollen. Die Anzahl der Trägerplättchen 6 wird so gewählt, daß ein sicheres Aufliegen des Referenzsubstrates 1 auf dem Substrathalter 16 gewährleistet ist.

Die Anordnung des Sensors, der aus dem Referenzsubstrat 1 und den Plättchen 6, 10 besteht, auf dem Substrathalter 16 zeigt Figur 7. Dabei ist der Sensor so ausgeführt, daß die Anordnung des Sensors auf dem Substrathalter 16 ohne Schwierigkeiten in der Beschichtungskammer erfolgen kann, zum Beispiel mit Hilfe eines Roboters. Der Substrathalter 16 weist dazu Kontaktelemente 17, zum Beispiel Kontaktstifte, auf, die federnd im Substrathalter 16 angeordnet sind. Der Sensor wird nun so auf den Substrathalter 16 aufgelegt, daß die Meßplättchen 10 Kontakt mit den Kontaktelementen 17 haben. Eine besondere Befestigung des Sensors am Substrathalter 16 ist an sich nicht notwendig, kann aber vorgesehen sein. Dies ist in Figur 7 durch die Halterungen 15 angedeutet. Die Kontaktelemente 17 sind mit einer Meßanordnung 20 verbunden, die entsprechend der Meßanordnung der bereits zitierten deutschen Patentschrift 31 23 427 aufgebaut sein kann. Die Meßanordnung 20 kann dabei im Substrathalter 16 liegen oder unterhalb des Substrathalters 16, wobei die Lage der Meßanordnung 20 zum Substrathalter 16 so gewählt ist, daß sie an der kühlsten Stelle des Substrathalters 16 liegt.

Die Kontaktelemente 17 sind federnd im Substrathalter 16 gelagert. Die Federkraft ist so gewählt, daß die Kontaktelemente 17 an die Meßplättchen 10 angedrückt werden. Wenn jedoch ein normales Substrat aufliegt, werden die Kontaktelemente 17 durch das Substrat in den Substrathalter 16 hineingedrückt, um ein gleichmäßiges Aufliegen des normalen Substrates auf dem Substrathalter 16 zu gewährleisten. Damit kann der Bereich des Substrathalters 16, in dem die Kontaktelemente 17 liegen, auch bei Nichtverwendung zu Meßzwecken zur Aufnahme von normalen Substraten herangezogen werden.

Wenn der Sensor in der Beschichtungskammer auf dem Substrathalter 16 angeordnet worden ist, kann mit der Beschichtung begonnen werden. Dabei wird der Bereich des Referenzsubstrates 1 zwischen den Leiterbahnen 2 und die Plättchen 6, 10 beschichtet. Damit entsteht eine elektrische Verbindung zwischen den Leiterbahnen 2. Mit Hilfe der Messung des Potentials an den Kontaktbereichen 3 der Leiterbahnen oder des durch die zwischen den Leiterbahnen 2 sich bildende Schicht fließenden Stromes kann zum Beispiel der Widerstand der Schicht zwischen den Leiterbahnen 2 berechnet werden oder wenn ein Thermoelement zwischen den Leiterbahnen 2 angeordnet ist die Temperatur im Referenzsubstrat fesgestellt werden. Es ist zudem eine Messung des Plasmastromes mit Hilfe der an den Kontaktbereichen 3 abgegriffenen Meßwerte möglich.

Selbstverständlich kann der Sensor auch dann verwendet werden, wenn eine von vornherein auf dem Referenzsubstrat zwischen den Leiterbahnen 2 angebrachte Schicht durch einen Ätzvorgang langsam abgetragen wird.

Bei der Beschichtung, die in Figur 7 von oben erfolgt, wird nicht nur das Referenzsubstrat 1 beschichtet sondern auch die am Referenzsubstrat befestigten Plättchen 10, 6. Dann ist es vorteilhaft, daß die Trägerplättchen 6 den Nippel 14 an dem Blech aufweisen, das dem Substrathalter 16 abgewandt ist. Damit entsteht in diesem Bereich ein Abstand zwischen dem Blech und dem Referenzsubstrat 1, der bei der Beschichtung verhindert, daß unerwünschte Kontaktbrücken über die Trägerplättchen 6 entstehen.

Weitere Vorteile der Erfindung sind darin zu sehen, daß der Sensor bestehend aus dem Referenzsubstrat 1 und dem Plättchen 10, 6 nur eine geringe Höhe von zum Beispiel 1,5 mm hat. Der Sensor ist zudem so ausgeführt, daß er direkt auf den Substrathalter 16 aufgelegt werden kann. Die Folge ist, daß die Meßanordnung 20 am Substrathalter 16 dort angeordnet werden kann, wo dessen kühlste Stelle ist.

## Patentansprüche

1. Sensor zum Messen des Stromes oder der Spannung von auf einem Referenzsubstrat (1) abgeschiedenen elektrisch leitenden Schichten mittels einer Meßanordnung (20), insbesondere zur Feststellung des Widerstandes oder der Temperatur des Referenzsubstrates (1),
wobei
- das Referenzsubstrat (1) auf einem Substrathalter (16) angeordnet ist,
- im Substrathalter (16) mit der Meßanordnung (20) verbundene Kontaktelemente (17) angeordnet sind, **gekennzeichnet durch** folgende Merkmale:
- das Referenzsubstrat (1) weist mindestens zwei getrennte Leiterbahnen (2, 3) auf,
- es sind Trägerplättchen (6) auf das Referenzsubstrat (1) aufgesteckt,
- es sind Meßplättchen (10) auf das Referenzsubstrat (1) so aufgesteckt, daß Kontakt mit den Leiterbahnen (2, 3) hergestellt ist und die nicht derselben Leiterbahn (2, 3) zugeordneten Meßplättchen (10) keinen Kontakt miteinander haben,
- an den Meßplättchen (10) liegen die Kontaktelemente (17) an.

2. Sensor nach Anspruch 1, **dadurch gekennzeichnet,** daß die Kontaktelemente (17) mit der Meßanordnung (20) verbunden sind, die am/im Substrathalter (16) angeordnet ist.

3. Sensor nach Anspruch 1 oder 2, **dadurch gekennzeichnet,** daß jedes Meßplättchen (10) aus zwei von einem Distanzplättchen (12) getrennten Blechen (11, 13) besteht, von denen das eine Blech (13) einen nach innen ragenden, bei aufgestecktem Meßplättchen auf dem Referenzsubstrat (1) aufliegenden Nippel (14) aufweist.

4. Sensor nach einem der vorhergehenden Ansprüche, **dadurch gekennzeichnet,** daß jedes Trägerplättchen (6) aus zwei von einem Distanzplättchen (8) getrennten Blechen (7, 9) besteht, von denen das eine Blech (7) einen nach innen ragenden, bei aufgestecktem Trägerplättchen auf dem Referenzsubstrat (1) aufliegenden Nippel (14) aufweist.

5. Sensor nach Anspruch 4, **dadurch gekennzeichnet,** daß das Referenzsubstrat (1) mit aufgesteckten Trägerplättchen (6) und Meßplättchen (10) so auf den Substrathalter (16) aufgelegt ist, daß die Nippel (14) an den vom Substrathalter (16) abgewandten Blechen der Träger- und Meßplättchen angeordnet sind.

6. Sensor nach Anspruch 5, **dadurch gekennzeichnet,** daß das dem Substrathalter (16) zugewandte Blech (9) des Trägerplättchens (6) dicker ist als das entsprechende Blech des Meßplättchens (10).

7. Sensor nach einem der vorhergehenden Ansprüche, **dadurch gekennzeichnet,** daß die Kontaktelemente (17) so federnd im Substrathalter (16) angeordnet sind, daß sie bei Aufliegen eines normalen Substrates nicht aus dem Substrathalter herausragen.

8. Sensor nach einem der vorhergehenden Ansprüche, **dadurch gekennzeichnet,** daß die Abmessungen von Referenzsubstrat (1) mit aufgesteckten Trägerplättchen und Meßplättchen (6, 10) an eine Fördereinrichtung angepaßt sind.

## Claims

1. Sensor for measuring the current or the voltage of deposited electrically conductive layers by means of a measurement arrangement (20), which layers are deposited on a reference substrate (1), especially for determining the resistance or the temperature of the reference substrate (1), the reference substrate (1) being arranged on a substrate holder (16), contact elements (17) which are connected to a measurement arrangement (20) being arranged in the substrate holder (16), characterised by the following features:
- the reference substrate (1) has at least two separate conductor tracks (2, 3),
- carrier platelets (6) are plugged onto the reference substrate (1),
- measurement platelets (10) are plugged onto the reference substrate (1) such that contact is produced with the conductor tracks (2, 3) and the measurement platelets (10) which are not allocated to the same conductor track (2, 3) make no contact with one another,
- the contact elements (17) rest on the measurement platelets (10).

2. Sensor according to Claim 1, characterised in that the contact elements (17) are connected to the measurement arrangement (20) which is arranged on/in the substrate holder (16).

3. Sensor according to Claim 1 or 2, characterised in that each measurement platelet (10) comprises two metal sheets (11, 13) which are separated by a spacer platelet (12), of which metal sheets the one metal sheet (13) has a nipple (14) which projects inwards and rests on the reference substrate (1) when the measurement platelet is plugged on.

4. Sensor according to one of the preceding claims,. characterised in that each carrier platelet (6) comprises two metal sheets (7, 9) which are separated by a spacer platelet (8), of which metal sheets the one metal sheet (7) has a nipple (14) which projects inwards and rests on the reference substrate (1) when the carrier platelet is plugged on.

5. Sensor according to Claim 4, characterised in that the reference substrate (1) is placed on the substrate holder (16) with the carrier platelets (6) and measurement platelets (10) plugged on, such that the nipples (14) are arranged on the metal sheets of the carrier and measurement platelets facing away from the substrate holder (16).

6. Sensor according to Claim 5, characterised in that the metal sheet (9) of the carrier platelet (6) facing the substrate holder (16) is thicker than the corresponding metal sheet of the measurement platelet (10).

7. Sensor according to one of the preceding claims, characterised in that the contact elements (17) are arranged in a sprung manner in the substrate holder (16) such that they do not project out of the substrate holder when a normal substrate rests thereon.

8. Sensor according to one of the preceding claims, characterised in that the dimensions of the reference substrate (1) are matched to a conveying direction with the carrier platelets and measurement platelets (6, 10) plugged on.

## Revendications

1. Capteur pour la mesure du courant ou de la tension de couches électriquement conductrices, déposées sur un substrat de référence (1), au moyen d'un dispositif de mesure (20), notamment pour la détermination de la résistance ou de la température du substrat de référence (1), et dans lequel
- le substrat de référence (1) est déposé sur un porte-substrat (16),
- des éléments de contact (17) raccordés au dispositif de mesure (20) sont disposés dans le porte-substrat (16),
caractérisé par les particularités suivantes :
- le substrat de référence (1) comporte au moins deux voies conductrices séparées (2,3),
- les plaquettes de support (6) sont enfichées sur le substrat de référence (1),
- des plaquettes de mesure (10) sont enfichées sur le substrat de référence (1) de telle sorte que le contact est établi avec les voies conductrices (2,3) et que les plaquettes de mesure (10), qui ne sont pas associées à la même voie conductrice (2,3) n'ont aucun contact entre elles, et
- les éléments de contact (17) sont situés sur les plaquettes de mesure (10).

2. Capteur suivant la revendication 1, caractérisé par le fait que les éléments de contact (17) sont reliés au dispositif de mesure (20) qui est disposé sur/dans le porte-substrat (16).

3. Capteur suivant la revendication 1 ou 2, caractérisé par le fait que chaque plaquette de mesure (10) est constituée par deux tôles (11,13), qui sont séparées par une plaquette entretoise (12), l'une des tôles (13) possédant un bouton (14) qui fait saillie intérieurement et s'applique sur le substrat de référence (1) lorsque la plaquette de mesure est enfichée.

4. Capteur suivant l'une des revendications précédentes, caractérisé par le fait que chaque plaquette de support (6) est constituée de deux tôles (7,9) séparées par une plaquette entretoise (8), l'une des tôles (7) possédant un bouton (14) qui fait saillie vers l'intérieur et s'applique sur le substrat de référence (1) lorsque la plaquette de support est enfichée.

5. Capteur suivant la revendication 4, caractérisé par le fait que le substrat de référence (1), sur lequel sont enfichées des plaquettes de support (6) et des plaquettes de mesure (10), est monté sur le porte-substrat (16) de telle sorte que les boutons (14) sont situés sur les tôles, tournées à l'opposé du porte-substrat (16), des plaquettes de support et les plaquettes de mesure.

6. Capteur suivant la revendication 5, caractérisé par le fait que la tôle (9), tournée vers le porte-substrat (16) de la plaquette de support (6) est plus épaisse que la tôle correspondante de la plaquette de mesure (10).

7. Capteur suivant l'une des revendications précédentes, caractérisé par le fait que les éléments de contact (17) sont montés élastiquement dans le porte-substrat (16) de sorte que lors de l'application d'un substrat normal, ils ne font pas saillie hors du porte-substrat.

8. Capteur suivant l'une des revendications précédentes, caractérisé par le fait que les dimensions du substrat de référence (1), sur lequel sont enfichées des plaquettes de support et des plaquettes de mesure (6,10), sont adaptées à un dispositif d'entraînement.
